# EUROPEAN PATENT SPECIFICATION

(11) **EP 0 913 696 B1**
(45) Date of publication and mention of the grant of the patent: **15.09.2004**
(21) Application number: 98660101.1
(22) Date of filing: 09.10.1998
(51) Int. Cl.: H05K 7/14

(54) **Modular apparatus for metering of electric energy**
Modulare Vorrichtung zum elektrischen Verbrauchzählen
Appareil modulaire pour le comptage d'énergie électrique

(30) Priority: 28.10.1997 FI 974075
(43) Date of publication of application: 06.05.1999
(73) Proprietor: ENERMET OY, SF-40420 Jyskä (FI)
(72) Inventor: Koistinen, Jukka, 40800 Vaajakoski (FI); Warmerdam, Petrus, 8620 Wetzikon (CH); Schellinger, Erich, MT Warren Park, QLD 4207 (AU); Airaksinen, Risto, 40420 Jyskä (FI)
(74) Representative: Stellberg, Hans

(56) References cited:
- EP-A- 0 421 320
- CH-A- 684 215
- PATENT ABSTRACTS OF JAPAN vol. 1996, no. 01, 31 January 1996 (1996-01-31) & JP 07 244094 A (TOSHIBA METER TECHNO KK;OTHERS: 01), 19 September 1995 (1995-09-19)

## Description

The invention concerns an apparatus for metering of electric energy as defined in the preamble of claim 1.

Meters that meter electric energy, including static electronic meters, have normally been constructed so that auxiliary apparatuses for the meter, such as receivers of network commands, communication means for remote reading, and equivalent, have been installed either in a separate box outside the meter, for example on a shield cover of the connector block, or in the interior of the meter box.

Auxiliary apparatuses installed in the interior of the meter are favoured, because they reduce the cost of installation and the overall space required by the meter construction. Such a solution, however, involves the problem that, in connection with replacement or after-installation of auxiliary apparatuses, the meter box must be opened, and the calibration seal provided on one screw that keeps the meter box closed must be broken. This is why, after replacement or after-installation of the auxiliary apparatuses, the meter must be calibrated again in a meter repair workshop, which causes additional expenses.

Unlike the metering circuits in metering apparatuses that meter electric energy, the receivers of network commands, communication apparatuses needed for remote reading, and equivalent develop very rapidly. Thus, from the point of view of the customer, it would be advantageous if these auxiliary apparatuses could be replaced in the field without having to break the calibration seals of the electricity meter.

In the **US Patent No. 5,317,250**, a modular apparatus for metering of electric energy is described, in which there is a box composed of a bottom part and a cover part. At the front edge of the bottom part, there is additionally a connector block, which is covered with a separate shield cover. In the interior of the box, it is possible to install the modules necessary for metering of electric energy as well as possible other modules, such as modules needed for receiving of network commands and for remote reading. In this solution, the auxiliary modules are placed in the interior of the meter box so that access to them is possible exclusively so that the cover of the box is opened, in which case, at the same time, the calibration seal of the meter must be broken. The invention of said US patent is actually concerned with the idea that the pairs of connectors in the connector block have been installed one above the other, in which case it has been possible to reduce the width of the meter box.

CH684215 discloses a modularly constructed electricity meter. The meter has a housing bottom part having guide elements and snap springs for receiving and irreversibly holding measurement printed circuit boards. The modular electricity meter can be manufactured in different degrees of complexity using the housing and modular assemblies.

In the **EP Patent 421320**, a box of a meter for electric energy consisting of a bottom plate and of a box-like cover part is described. Further, in the cover part, there is an opening that can be closed by means of a separate cover. Onto the bottom plate, first the cover part is installed, which is closed in relation to the bottom plate by means of seals. After this, onto the opening on the cover part, the cover is fitted, which is closed in relation to the cover part by means of seals. Through said opening in the cover part, access is provided to a compartment formed under the cover, into which compartment an auxiliary function card can be installed. Thus, access is provided to the compartment that receives the auxiliary function card through the front face (cover face) of the box. In this solution, the auxiliary function card can be replaced without breaking the seals on the cover part.

The principal characteristic features of the apparatus for metering of electric energy in accordance with the present invention are disclosed in the characterizing part of claim 1.

In the solution in accordance with the present invention, in the interior of the apparatus for metering of electric energy, a separate compartment for auxiliary cards has been arranged, to which the optional auxiliary cards, which consist of integrated electronic circuit cards that include one or several functional properties, can be connected. This compartment for auxiliary cards has been designed so that its front side, through which the cards of auxiliary functions are inserted into the compartment and removed from the compartment, is opened into the side wall of the meter box placed at the side of the connector block. On the other hand, into said side wall, an opening has been arranged so that through this opening access is provided to the cards for auxiliary functions without opening the cover of the meter box. Said opening can be closed by means of a separate cover of its own which can be sealed, or said opening can also be placed under the cover of the connector block provided at the side wall of the box, in which case access to said compartment is provided so that the cover of the connector block is opened, which cover is also a cover that can be closed by means of a seal.

In the auxiliary card compartment of the metering apparatus in accordance with the present invention, for example, a pulse input/output card, serial interface card, LON data transfer card, network command receiver card, receiver/transmitter card for the "MELKO" system, telephone modem card, radio modem card can be installed. It is also possible to think that the auxiliary function card contains additional memory for the meter only.

The auxiliary card compartment has also been designed so that an electric connection is formed between the auxiliary function card or cards and the other electronic circuits of the meter when the auxiliary function card or cards is/are installed on the connector means of said compartment. Further, the auxiliary function cards have been designed so that they can also be connected to apparatuses outside the meter when the opening placed in the side wall of the box and passing to the auxiliary device compartment is open.

The auxiliary card compartment has been designed so that it has a detachable partition wall, by whose means the auxiliary card compartment can be divided into two parts. When the partition wall is not in its place, one auxiliary function card that extends across the whole width of the auxiliary card compartment can be installed into the auxiliary card compartment, and when the partition wall is in its place, two narrower auxiliary function cards placed side by side can be installed into the auxiliary card compartment.

If more than two auxiliary function cards are needed for the meter, the auxiliary card compartment can be so high that the auxiliary function cards can be fitted one above the other in the auxiliary card compartment. In most cases, however, an auxiliary card compartment is likely to be sufficient in which there is space for no more than two auxiliary function cards.

The auxiliary card compartment of the apparatus for metering of electric energy in accordance with the invention is also provided with a lock device that can be operated from inside the meter box. By means of said lock device, the auxiliary function card or cards can be locked in its/their place so that they cannot be detached without removing the cover of the meter box, in which case the calibration seal of the screw that keeps the cover of the meter box closed must also be broken.

The construction in accordance with the invention of an apparatus for metering of electric energy can be used both in connection with a three-phase meter and in connection with a single-phase meter. As the circuit of metering of electric energy in the meter, in principle, it is possible to employ any static metering circuit whatsoever, to which circuit, when necessary, different metering devices are connected.

In the following, the invention will be described in more detail with reference to the figures in the accompanying drawings, the invention being, however, not supposed to be confined to the details of said illustrations alone.
Figures 1A and 1B are an exploded view illustrating the modules of the apparatus for metering of electric energy in accordance with the invention.
Figure 2 illustrates a lock device for the auxiliary function cards.

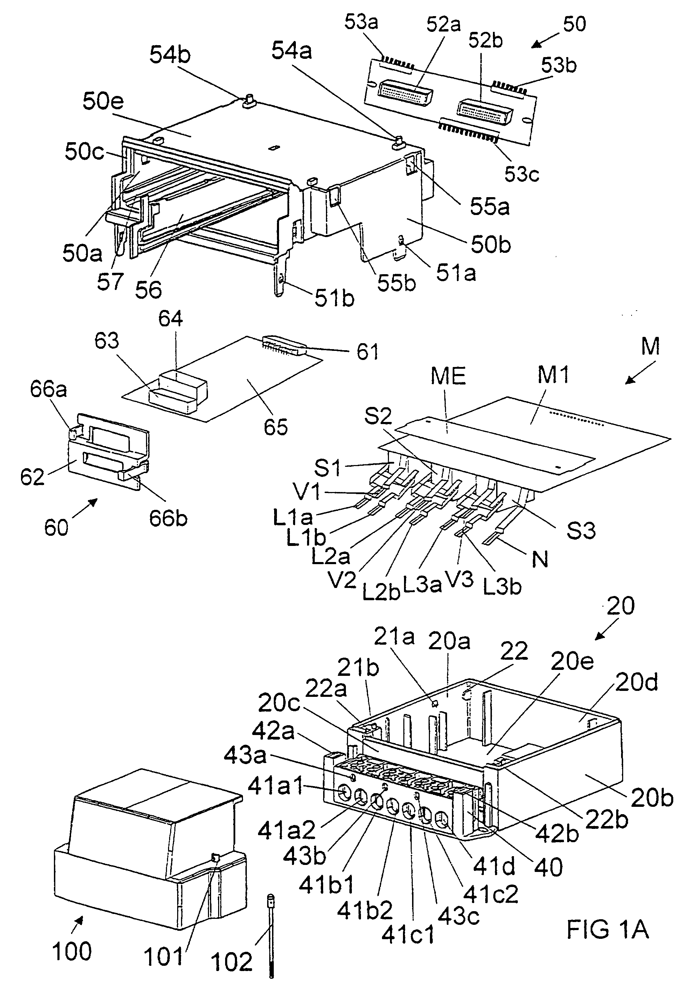

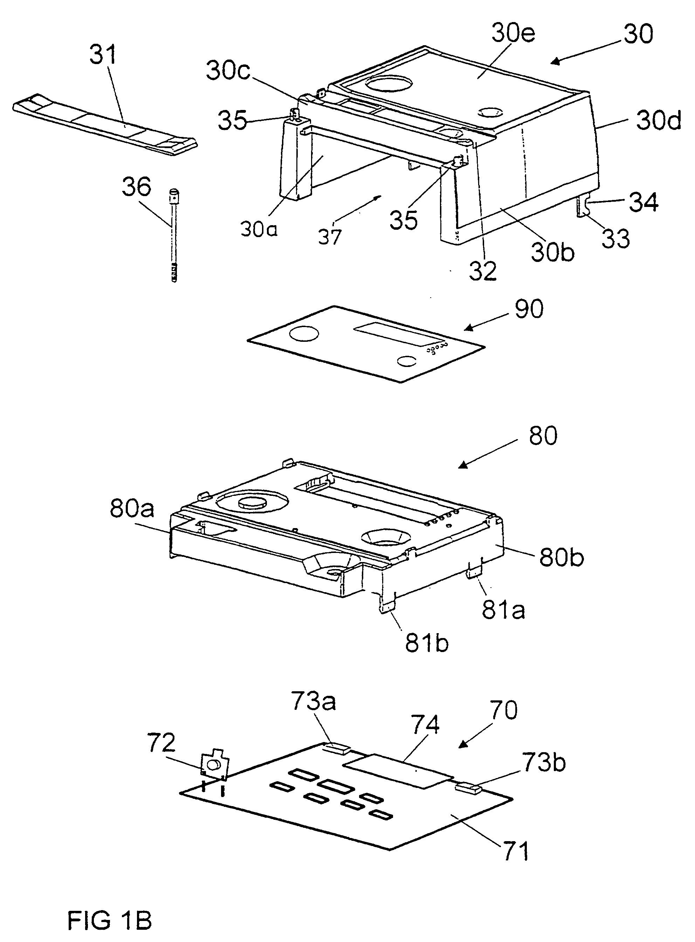

The apparatus for metering of electric energy in accordance with the present invention shown in Figs. 1A and 1B consists of a box-like case, which comprises a bottom part 20 and a cover part 30. The bottom part 20 of the box consists of a first side wall 20a, a second side wall 20b, a front wall 20c, a rear wall 20d, and of a bottom plate 20e. Moreover, in the front wall 20c of the bottom part 20 of the box, there is a connector block 40, to whose terminals 41a1, 41b1, 41c1 the phase conductors of the electricity feed cable coming from the distribution network of the electricity plant are connected. The phase conductors of the electricity feed cable of the consumption site supplied through the meter are again connected to the terminals 41a2, 41b2, 41c2 of the connector block 40. The terminal 41d in the connector block 40 is the neutral terminal. If a meter connected to a current transformer / voltage transformer is used, the terminals 43a, 43b, 43c are connected to the phases of the electricity network or to the voltage metering transformers.

Onto the bottom part 20 of the box, the module M proper for metering of electric current is installed. The metering module M consists of an integrated electronic circuit card M1, of connected current metering transformers S1, S2, S3, and of connector strips L1a, L1b, L2a, L2b, L3a, L3b, N, V1, V2, V3 fitted onto the terminals 41a1, 41a2, 41b1, 41b2, 41c1, 41c2, 41d, 43a, 43b, 43c in the connector block 40 on the front wall 20c of the bottom part 20 of the box. What is concerned is a metering module M for three-phase electric energy, in which the connector strips L1a and L1b are connected with the first phase, the connector strips L2a and L2b with the second phase, the connector strips L3a and L3b with the third phase, and the connector strip N with neutral. The connector strips L1a, L1b, L2a, L2b, L3a, L3b are connected through said current transformers S1, S2, S3 to the circuit card M1 of the metering module M. The connector strip N is connected directly to the circuit card M1 of the metering module M. The connector strips V1, V2, V3 are connected to the phases of the electricity network, or to voltage metering transformers when a meter connected to a current transformer / voltage transformer is concerned.

Onto the circuit card M1 at the current transformers S1, S2, S3, an interference protection plate ME has been installed, by whose means transfer of any interference that may be produced by the current transformers S1, S2, S3 to the other electronic circuits of the meter, placed above the metering module M, is prevented. The circuit card M1 of the metering module M is placed substantially at the level of the top edges of the side walls 20a, 20b, front wall 20c, and rear wall 20d of the bottom part 20a of the box 20.

The compartment that receives the auxiliary function cards consists of a frame part 50, which comprises a first 50a and a second side wall 50b, a deck plate 50e that interconnects said side walls, a detachable rear circuit card 50d, a front wall 50c provided with an opening, and a detachable partition wall 56.

The rear circuit card 50d of the frame part 50 can be attached to the side walls 50a, 50b of the frame part 50, for example, by means of screws. The rear circuit card 50d of the frame part 50 includes the connector interfaces 52a, 52b for auxiliary function cards 60 as well as the connectors 53a, 53b, 53c. The connectors 53a, 53b are connected to the application module 70 to be fitted on the top of the frame part 50, and the connector 53c is connected to the metering module M placed at the bottom of the frame part 50. Thus, by means of the connectors 52a, 52b, 53a, 53b, 53c of the rear circuit card 50d of the frame part 50, electric connections are formed between the application module 70, the metering module M, and possible auxiliary function cards 60, if any.

Further, on the side walls 50a, 50b and on the partition wall 56 in the frame part, there are guide grooves 57, along which the auxiliary function cards 60 can be pushed into the frame part 50. The frame part 50 is installed onto the metering module M so that the side walls 50a, 50b of the frame part 50 enclose the circuit card M1 of the metering module M. The side walls 50a, 50b of the frame part 50 are provided with first projections 51a, 51b, which are positioned into the openings 21a, 21b provided in the inner faces of the side walls 20a, 20b of the bottom part 20 of the box 10 and lock the frame part 50 in its position.

The auxiliary function cards 60 consist of an integrated electronic circuit card 65, in whose rear part there is a connector 61, which is fitted into the connector 52a, 52b in the rear wall 50d of the frame part 50 and forms a contact between the connector pins of said connectors when the auxiliary function card 60 is pushed into the frame part 50 along the guide grooves 57. At the front edges of the auxiliary function cards 60, there is/are one or several connectors 63, 64, by whose means the auxiliary function card 60 can be connected to apparatuses outside the meter. The auxiliary function cards 60 are attached to the frame part 50 by means of a fastening device 62. The fastening device 62 includes two clamp devices 66a, 66b, by whose means the fastening device 62 and, thereby, the auxiliary function card 60 are attached to the frame part 50 so that they cannot glide out of the frame part 50. By means of the fastening device 62, it is also possible to close the opening in the front wall 50c of the frame part 50 while there is/are no auxiliary function card or cards fitted in their place in the frame part 50.

The application module 70, which also consists of an integrated electronic circuit card 71, is installed onto the fastening pins 54a, 54b provided on the deck plate 50d of the frame part 50 for auxiliary function cards 60. Further, the application module 70 may include a battery 72, by whose means the supply of electricity to the clock circuits of the circuit card 71 of the application module is secured during breaks of supply in the mains network. The application module 70 also includes connectors 73a, 73b that receive the connector pins of the connectors 53a, 53b on the rear wall 50c of the frame part 50. Further, the application module 70 includes a display 74, by whose means the consumption of electric energy metered by the meter is displayed. The application module 70 includes a user interface and all functions that are connected with the collecting, processing and storage of the metering data.

In the side walls 50a, 50b of the frame part 50, there are also second openings 55a, 55b, which receive the hook-shaped projections 81a, 81b provided on the side walls 80a, 80b of the holder part 80 which is to be mounted onto the application module 70 and which encloses the application module 70 in its interior, by means of which projections 81a, 81b the holder part 80 is locked onto the frame part 50 for the auxiliary function cards 60.

Onto the holder part 80, a name plate 90 is fitted, and the topmost part will be the cover part 30 of the box, which is positioned against the bottom part 20 of the box and encloses the apparatuses installed on said bottom part 20.

The cover part 30 consists of a first side wall 30a, of a second side wall 30b, of a front wall 30c, of a rear wall 30d, and of a deck plate 30e interconnecting said walls. The cover part 30 is further connected with a closing gate 31, which can be pushed into the grooves 32 provided on the cover part. The cover part 30 is attached to the bottom part 20 by means of notches 34 provided in projections 33 provided on the side walls 30a, 30b of the cover part near the rear wall 30d, which notches 34 are fitted into engagement with projections 22 provided on the inside faces of the side walls 20a, 20b of the bottom part 20. Further, in the side walls 30a, 30b of the cover part 30, at the front edge 30c, there are holes 35, into which the fastening screws 36 can be installed, which extend into the threaded holes 22a, 22b in the bottom part 20 and by whose means the cover part 30 is fixed to the bottom part 20. At least one of said fastening screws 35 can be locked by means of a seal so that it cannot be opened without breaking the seal. This seal is a what is called calibration seal, i.e. if this seal is broken, the meter must be calibrated again at a meter workshop.

After the cover part 30 has been fixed to the bottom part 20, an opening 37 remains at the forward edge 30c of the cover part 30, through which opening access is provided to the front edge 50c of the frame part 50 which receives the auxiliary function cards 60. Through said opening 37, an auxiliary function card 60 can be pushed into the frame part 50.

When the auxiliary function card 60 or cards is/are in their place, the cover 100 of the connector block 40 can be fitted in its place on the connector block 40. The cover 100 of the connector block extends upwards so that, besides the connector block 40, it also covers the opening 37 at the front edge 30c of the cover part 30 of the box and, thus, also the auxiliary function cards 60. At the sides of the cover 100 of the connector block 40, there are holes 101, from which the cover 100 can be attached by means of screws 102 to corresponding threaded holes 42a, 42b provided on the connector block 40. At least one of the screws 102 can again be provided with a seal so that the screw 102 cannot be opened without breaking the seal.

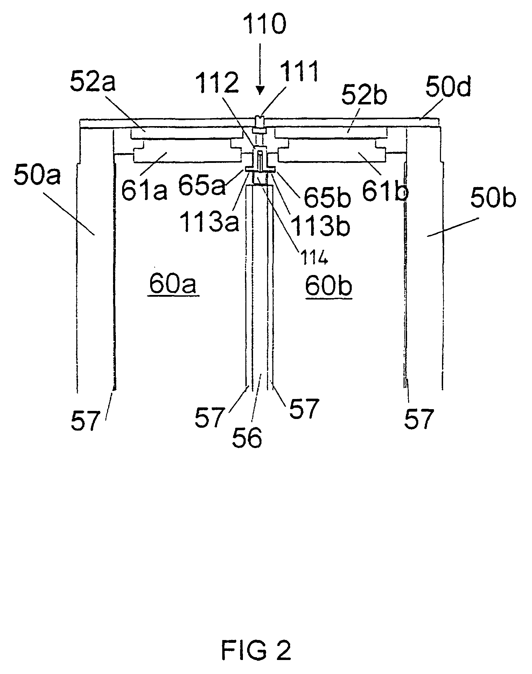

Fig. 2 shows a lock device 110 attached to the rear circuit card 50d of the frame part 50, by means of which lock device the auxiliary function cards 60a, 60b can be locked on the frame part 50. The lock device 110 consists of a rotatable spindle part 112, whose end that is directed towards the rear circuit card 50d of the frame part 50 is provided with a slot 111 and whose end that is directed towards the interior of the frame part 50 is provided with wings 113a, 113b projecting in opposite directions. The spindle part 112 is placed in a vertical support 114 attached to the deck plate 50e of the frame part 50 and directed downwards. When the spindle part 112 is rotated by means of the slot 111 so that the wings 113a, 113b are in the vertical plane, the auxiliary function cards 60a, 60b can be removed from their place by pulling them through the opening 37 out of the frame 50. In such a case the auxiliary function cards 60a, 60b glide on support of the guide grooves 57 provided on the side walls 50a, 50b and on the partition wall 56 in the frame part 50 out of the frame part 50, and the connectors 52a, 61a and 52b, 61b are separated from one another. When the spindle part 112 is rotated by means of the slot 111 so that the wings 113a, 113b are in the horizontal plane in the way shown in the figure, the wings 113a, 113b are positioned into the recesses 65a, 65b provided on the auxiliary function cards 60a, 60b, in which connection the auxiliary function cards 60a, 60b have been locked with the spindle part 112. A movement of the spindle part 112 outwards from the frame part 50 is again prevented by said vertical support 114, so that, when the wings 113a, 113b are in the horizontal plane in the way shown in the figure, the auxiliary function cards 60a, 60b are locked in the frame part 50. As the slot 111 on the spindle part 112 of the lock device 110 is placed in an opening formed into the rear circuit card 50d of the frame part 50, access to the lock device is possible in a situation only in which the cover part 30 of the box of the meter has been removed, in which case the calibration seal of the meter has been broken.

The spindle part 112 has been arranged preferably so that it is locked in the position in which the wings 113a, 113b are in a substantially horizontal plane and in the position in which they are in a substantially vertical plane. This can be arranged, for example, so that onto the support column 114 a projection of quadrangular section is provided, which extends into a recess, likewise of quadrangular section, that has been formed into the spindle part 112. The spindle part 112 and said projection on the support column are locked with each other when the quadrangles coincide with each other, but, since the walls of the recess in the spindle part 112 yield slightly, the spindle part 112 can be forced, by rotating by means of a tool from the slot 111, to be shifted between the two locking positions mentioned above.

In Fig. 2, the lock device 110 is shown in a situation in which there is a partition wall 56 in the frame part 50 and in which two smaller auxiliary function cards 60a, 60b have been inserted into the frame part 50. The lock device 110 also operates in a situation in which there is an auxiliary function card, e.g. 60a, in one of the compartments separated by the partition wall 56 only, whereas the other compartment is empty. The lock device 110 can, of course, also be used in a situation in which there is no partition wall 56 in the frame part 50 and in which one larger auxiliary function card 60 has been inserted into the frame part 50. In such a case, in the rear part of the auxiliary function card 60, in the region of the lock device 110, there is an opening corresponding to the situation shown in Fig. 2, into which opening the spindle part 112 of the lock device 110 can penetrate, and at the edges of the opening there are recesses 65a, 65b, into which the wings 113a, 113b of the lock device 110 are positioned while locking the auxiliary function card 60 in its place.

In the following, the patent claims will be given, and the details of the invention can show variation within the scope of the inventive idea defined in said claims and differ from what has been stated above by way of example only.

## Claims

1. A modular apparatus for metering of electric energy comprising a box-like case composed of a bottom part (20) and of a cover part (30) being attached to the bottom part and closed by means of a calibration seal, said box-like case comprising a first side wall (20a, 30a), a second side wall (20b, 30b) opposite to the first side wall, a third side wall (20c, 30c) interconnecting first edges of the first and the second side wall, a fourth side wall (20d, 30d) opposite to the third side wall interconnecting second edges of the first and the second side wall, a bottom plate (20e) interconnecting first ends of said side walls, and a deck plate (30e) opposite to the bottom plate interconnecting second ends of said side walls, the apparatus further comprising a number of modules (M, 50, 70, 80, 90) that perform different functions being fitted in the interior of the box-like case, at least one module being a metering circuit (M) that meters electric energy, a connector block (40) attached to a side wall (20c) of the bottom part (20), a cover (100) covering the connector block (40), and a compartment (50) inside the box-like case that receives at least one auxiliary function card (60), **characterized in that** said compartment (50) has an opening (37) provided in the side wall (30c) of the cover part (30) that is on the same side as the connector block (40), through which opening the at least one auxiliary function card (60) can be installed into said compartment (50) and removed from said compartment (50) so that the cover part (30) of the box-like case does not have to be separated from the bottom part (20) of the box-like case, whereby the calibration seal of the metering apparatus does not have to be broken either.

2. A metering apparatus as claimed in claim 1, **characterized in that** the apparatus comprises a cover (100) of the connector block (40), which cover, when installed in its place, besides closing access to connectors on the connector block (40), also extends to close access to said opening (37) through which the at least one auxiliary function card (60) can be installed into an removed from said compartment (50), whereby it is possible to replace the at least one auxiliary function card (60) by removing the cover (100) of the connector block (40).

3. A metering apparatus as claimed in claim 1, **characterized in that** the apparatus comprises a separate cover, by whose means the opening (37) through which the at least one auxiliary function card (60) can be installed into an removed from said compartment (50) is closed, whereby the at least one auxiliary function card (60) can be replaced by removing said separate cover.

4. A metering apparatus as claimed in any of the claims 1 to 3, **characterized in that** the auxiliary function cards (60) are placed in said compartment (50) on a number of levels.

5. A metering apparatus as claimed in any of the claims 1 to 3, **characterized in that** the auxiliary function cards (60) are placed in said compartment (50) on one level.

6. A metering apparatus as claimed in claim 4, **characterized in that** said compartment (50) can be divided by means of a detachable partition wall (56) into two parts, in which case, after the partition wall (56) has been removed, a number of auxiliary function cards (60) placed on different levels and extending across the width of the whole compartment (50) can be fitted in the compartment (50), and, when the partition wall (56) is in its place, a number of auxiliary function cards (60) can be fitted in the compartment (50) so that they are placed on a number of levels, on each of which levels there are two auxiliary function cards (60) placed side by side.

7. A metering apparatus as claimed in claim 5, **characterized in that** said compartment (50) can be divided by means of a detachable partition wall (56) into two parts, in which case, after the partition wall (56) has been removed, one auxiliary function card (60) extending substantially across the width of the whole compartment (50) can be fitted in the compartment (50), and, when the partition wall (56) is in its place, two auxiliary function cards (60) placed side by side can be fitted in the compartment (50), each of said cards extending substantially across one half of the width of the compartment (50), one card being fitted in each half of the compartment.

8. A metering apparatus as claimed in any of the claims 1 to 7, **characterized in that** a circuit card (50d) forming a rear wall of said compartment (50) comprises connectors (53a, 53b), by which the auxiliary function cards (60) are connected to the application module (70) placed inside the box-like case, and a connector (53c), by whose means the metering module (M) is connected to the application module (70).

9. A metering apparatus as claimed in any of the claims 1 to 8, **characterized in that** in said compartment (50) there are guide grooves (57), which guide the auxiliary function cards (60) into the compartment (50) so that connectors (61) of the auxiliary function cards (60) are pressed onto corresponding connectors (52a, 52b) provided in the compartment (50) and secure a contact between the connectors.

10. A metering apparatus as claimed in any of the claims 1 to 9, **characterized in that** an end part of the auxiliary function cards (60) facing into said opening (37) is provided with one or several connectors (63, 64), which can be connected to an apparatus outside the meter after the cover that closes said opening (37) has been removed from the meter.

11. A metering apparatus as claimed in any of the claims 1 to 10, **characterized in that** the compartment (50) that receives the auxiliary function cards (60) is provided with a lock device (110), by which the auxiliary function cards (60) can be locked in the compartment (50) so that their removal requires opening of the cover part (30) of the meter, in which connection the calibration seal of the meter must be broken.

## Patentansprüche

1. Modulare Vorrichtung zum Messen von elektrischer Energie, die ein kastenähnliches Gehäuse aufweist, welches aus einem Bodenteil (20) und einem Deckelteil (30) besteht, welches an dem Bodenteil befestigt und durch ein Eichsiegel verschlossen ist, wobei das kastenähnliche Gehäuse eine erste Seitenwand (20a,30a), eine der ersten Seitenwand gegenüberliegende zweite Seitenwand (20b,30b) und eine dritte Seitenwand (20c,30c) aufweist, die erste Kanten der ersten und der zweiten Seitenwand miteinander verbindet, wobei eine der dritten Seitenwand gegenüberliegende vierte Seitenwand (20d,30d) zweite Kanten der ersten und der zweiten Seitenwand miteinander verbindet, wobei eine Bodenplatte (20e) erste Enden der Seitenwände miteinander verbindet, und wobei eine der Bodenplatte gegenüberliegende Deckplatte (30e) zweite Enden der Seitenwände miteinander verbindet, wobei die Vorrichtung weiterhin eine Anzahl von Modulen (M,50,70,80,90) aufweist, die in dem Inneren des kastenähnlichen Gehäuses integrierte unterschiedliche Funktionen erfüllen, wobei mindestens ein Modul eine Messschaltung (M) ist, die elektrische Energie misst, einen an einer Seitenwand (20c) des Bodenteils (20) befestigten Klemmenblock (40), eine den Klemmenblock (40) abdeckende Abdeckung (100) und ein Abteil (50) innerhalb des kastenähnlichen Gehäuses aufweist, welches mindestens eine Hilfsfunktionskarte (60) aufnimmt,
**dadurch gekennzeichnet, dass**
das Abteil (50) eine in der Seitenwand (30c) des Deckelteils (30) vorgesehene Öffnung (37) aufweist, die sich auf derselben Seite wie der Klemmenblock (40) befindet, wobei durch diese Öffnung die mindestens eine Hilfsfunktionskarte (60) in dem Abteil (50) angebracht und von dem Abteil (50) entfernt werden kann, so dass das Deckelteil (30) des kastenähnlichen Gehäuses nicht von dem Bodenteil (20) des kastenähnlichen Gehäuses getrennt werden muss, wobei das Eichsiegel der Messvorrichtung ebenfalls nicht beschädigt werden muss.

2. Messvorrichtung nach Anspruch 1,
**dadurch gekennzeichnet, dass**
die Vorrichtung eine Abdeckung (100) des Klemmenblockes (40) aufweist, wobei sich die Abdeckung, wenn sie in ihrer Position angebracht ist, neben dem Verschließen des Zugangs zu den Klemmen auf dem Klemmenblock (40) auch so erstreckt, dass sie den Zugang zu der Öffnung (37) verschließt, durch welche die mindestens eine Hilfsfunktionskarte (60) in dem Abteil (50) angebracht und von demselben entfernt werden kann, wobei es möglich ist, die mindestens eine Hilfsfunktionskarte (60) durch Entfernen der Abdeckung (100) des Klemmenblockes (40) auszutauschen.

3. Messvorrichtung nach Anspruch 1,
**dadurch gekennzeichnet, dass**
die Vorrichtung eine separate Abdeckung aufweist, durch welche die Öffnung (37) verschlossen wird, durch welche die mindestens eine Hilfsfunktionskarte (60) in dem Abteil (50) angebracht und von demselben entfernt werden kann, wobei die mindestens eine Hilfsfunktionskarte (60) durch Entfernen der separaten Abdeckung ausgetauscht werden kann.

4. Messvorrichtung nach einem der Ansprüche 1 bis 3,
**dadurch gekennzeichnet, dass**
die Hilfsfunktionskarten (60) in dem Abteil (50) auf einer Anzahl von Ebenen positioniert sind.

5. Messvorrichtung nach einem der Ansprüche 1 bis 3,
**dadurch gekennzeichnet, dass**
die Hilfsfunktionskarten (60) in dem Abteil (50) auf einer Ebene positioniert sind.

6. Messvorrichtung nach Anspruch 4,
**dadurch gekennzeichnet, dass**
das Abteil (50) durch eine abnehmbare Trennwand (56) in zwei Teile teilbar ist, wobei in diesem Fall nach dem Entfernen der Trennwand (56) eine Anzahl von auf verschiedenen Ebenen positionierten und sich über die Breite des gesamten Abteils (50) erstreckenden Hilfsfunktionskarten (60) in dem Abteil (50) eingebaut werden kann, und dann, wenn sich die Trennwand (56) an ihrem Standort befindet, eine Anzahl von Hilfsfunktionskarten (60) in dem Abteil (50) eingebaut werden kann, so dass sie auf einer Anzahl von Ebenen positioniert sind, wobei auf jeder der Ebenen zwei Hilfsfunktionskarten (60) Seite an Seite positioniert sind.

7. Messvorrichtung nach Anspruch 5,
**dadurch gekennzeichnet, dass**
das Abteil (50) durch eine abnehmbare Trennwand (56) in zwei Teile teilbar ist, wobei in diesem Fall nach dem Entfernen der Trennwand (56) eine sich im Wesentlichen über die Breite des gesamten Abteils (50) erstreckende Hilfsfunktionskarte (60) in dem Abteil (50) eingebaut werden kann, und dann, wenn sich die Trennwand (56) an ihrem Standort befindet, zwei Seite an Seite positionierte Hilfsfunktionskarten (60) in dem Abteil (50) eingebaut werden können, wobei sich jede der Karten im Wesentlichen über eine Hälfte der Breite des Abteils (50) erstreckt, wobei in jeder Hälfte des Abteils eine Karte eingebaut ist.

8. Messvorrichtung nach einem der Ansprüche 1 bis 7,
**dadurch gekennzeichnet, dass**
eine Schaltungskarte (50d), die eine Rückwand des Abteils (50) ausbildet, Stecker (53a,53b) aufweist, durch welche die Hilfsfunktionskarten (60) mit dem innerhalb des kastenähnlichen Gehäuses positionierten Anwendungsmodul (70) verbunden werden, und einen Stecker (53c) aufweist, durch welchen das Messmodul (M) mit dem Anwendungsmodul (70) verbunden wird.

9. Messvorrichtung nach einem der Ansprüche 1 bis 8,
**dadurch gekennzeichnet, dass**
in dem Abteil (50) Führungsnuten (57) vorhanden sind, welche die Hilfsfunktionskarten (60) in das Abteil (50) führen, so dass Stecker (61) der Hilfsfunktionskarten (60) auf die in dem Abteil vorgesehenen entsprechenden Stecker (52a,52b) gedrückt werden und einen Kontakt zwischen den Steckern sicherstellen.

10. Messvorrichtung nach einem der Ansprüche 1 bis 9,
**dadurch gekennzeichnet, dass**
ein in die Öffnung (37) hinein gerichteter Endteil der Hilfsfunktionskarten (60) mit einem oder mehreren Steckern (63,64) versehen ist, die mit einer Vorrichtung außerhalb des Messgerätes verbunden werden können, nachdem die die Öffnung (37) verschließende Abdeckung von dem Messgerät entfernt wurde.

11. Messvorrichtung nach einem der Ansprüche 1 bis 10,
**dadurch gekennzeichnet, dass**
das die Hilfsfunktionskarten (60) aufnehmende Abteil (50) mit einer Arretierungsvorrichtung (110) versehen ist, durch welche die Hilfsfunktionskarten (60) in dem Abteil (50) arretiert werden können, so dass deren Entfernen das Öffnen des Deckelteils (30) des Messgerätes erfordert, wobei in diesem Zusammenhang das Eichsiegel des Messgerätes beschädigt werden muss.

## Revendications

1. Appareil modulaire pour la mesure de l'énergie électrique, comprenant un coffret semblable à une boîte, constitué d'une partie de fond (20) et d'une partie de couvercle (30) attachée à la partie de fond et fermée au moyen d'un sceau d'étalonnage, ledit coffret semblable à une boîte comprenant une première paroi latérale (20a, 30a), une seconde paroi latérale (20b, 30b) opposée à la première paroi latérale, une troisième paroi latérale (20c, 30c) reliant des premiers bords de la première et de la seconde parois latérales, une quatrième paroi latérale (20d, 30d) opposée à la troisième paroi latérale, reliant des seconds bords de la première et de la seconde parois latérales, une plaque de fond (20e) reliant des premières extrémités desdites parois latérales, et une plaque de couvercle (30e) opposée à la plaque de fond, reliant des secondes extrémités desdites parois latérales, l'appareil comprenant en outre un certain nombre de modules (M, 50, 70, 80, 90) qui remplissent différentes fonctions, montés à l'intérieur du coffret semblable à une boîte, au moins un module étant un circuit de mesure (M) qui mesure l'énergie électrique, un bloc de connecteurs (40) attaché à une paroi latérale (20c) de la partie de fond (20), un couvercle (100) recouvrant le bloc de connecteurs (40), et un compartiment (50) situé à l'intérieur du coffret semblable à une boîte, qui reçoit au moins une carte (60) de fonctions auxiliaires, **caractérisé en ce que** ledit compartiment (50) dispose d'une ouverture (37) prévue dans la paroi latérale (30c) de la partie de couvercle (30), qui est sur le même côté que le bloc de connecteurs (40), ouverture à travers laquelle la carte (60) de fonctions auxiliaires au moins présente peut être installée à l'intérieur dudit compartiment (50) et retirée dudit compartiment (50), de sorte que la partie de couvercle (30) du coffret semblable à une boîte ne doit pas être séparée de la partie de fond du coffret semblable à une boîte, moyennant quoi le sceau d'étalonnage de l'appareil de mesure ne doit pas non plus être cassé.

2. Appareil de mesure tel que revendiqué dans la revendication 1, **caractérisé en ce que** l'appareil comprend un couvercle (100) du bloc de connecteurs (40), lequel couvercle, lorsqu'il est installé à sa place, en plus de fermer un accès à des connecteurs du bloc de connecteurs (40), s'étend aussi pour fermer un accès à ladite ouverture (37) à travers laquelle la carte (60) de fonctions auxiliaires au moins présente peut être installée à l'intérieur, et retirée dudit compartiment (50), moyennant quoi il est possible de remplacer la carte (60) de fonctions auxiliaires au moins présente en retirant le couvercle (100) du bloc de connecteurs (40).

3. Appareil de mesure tel que revendiqué dans la revendication 1, **caractérisé en ce que** l'appareil comprend un couvercle séparé, au moyen duquel l'ouverture (37) à travers laquelle la carte (60) de fonctions auxiliaires au moins présente peut être installée à l'intérieur, et retirée dudit compartiment (50) est fermée, moyennant quoi le carte (60) de fonctions auxiliaires au moins présente peut être remplacée en retirant ledit couvercle séparé.

4. Appareil de mesure tel que revendiqué dans l'une quelconque des revendications 1 à 3, **caractérisé en ce que** les cartes (60) de fonctions auxiliaires sont placées dans ledit compartiment (50) sur un certain nombre de niveaux.

5. Appareil de mesure tel que revendiqué dans l'une quelconque des revendications 1 à 3, **caractérisé en ce que** les cartes (60) de fonctions auxiliaires sont placées dans ledit compartiment (50) sur un seul niveau.

6. Appareil de mesure tel que revendiqué dans la revendication 4, **caractérisé en ce que** ledit compartiment (50) peut être subdivisé en deux parties au moyen d'une paroi de séparation amovible (56), auquel cas, après que la paroi de séparation (56) a été retirée, un certain nombre de cartes (60) de fonctions auxiliaires placées sur différents niveaux et s'étendant sur la largeur de tout le compartiment (50) peuvent être montées dans le compartiment (50) et, lorsque la paroi de séparation (56) est à sa place, un certain nombre de cartes (60) de fonctions auxiliaires peuvent être montées dans le compartiment (50) de sorte qu'elles soient placées sur un certain nombre de niveaux, niveaux sur chacun desquels il y a deux cartes (60) de fonctions auxiliaires placées côte à côte.

7. Appareil de mesure tel que revendiqué dans la revendication 5, **caractérisé en ce que** ledit compartiment (50) peut être subdivisé en deux parties au moyen d'une paroi de séparation amovible (56), auquel cas, après que la paroi de séparation (56) a été retirée, une seule carte (60) de fonctions auxiliaires s'étendant essentiellement sur la largeur de tout le compartiment (50) peut être montée dans le compartiment (50) et, lorsque la paroi de séparation (56) est à sa place, deux cartes (60) de fonctions auxiliaires placées côte à côte peuvent être montées dans le compartiment (50), chacune desdites cartes s'étendant essentiellement sur une moitié de la largeur du compartiment (50), une carte étant montée dans chaque moitié du compartiment.

8. Appareil de mesure tel que revendiqué dans l'une quelconque des revendications 1 à 7, **caractérisé en ce qu'**une carte de circuit (50d) formant une paroi arrière dudit compartiment (50) comprend des connecteurs (53a, 53b), par lesquels les cartes (60) de fonctions auxiliaires sont reliées au module d'application (70) placé à l'intérieur du coffret semblable à une boîte, et un connecteur (53c), au moyen duquel le module de mesure (M) est relié au module d'application (70).

9. Appareil de mesure tel que revendiqué dans l'une quelconque des revendications 1 à 8 **caractérisé en ce que**, dans ledit compartiment (50), se trouvent des rainures de guidage (57), qui guident les cartes (60) de fonctions auxiliaires à l'intérieur du compartiment (50) de sorte que des connecteurs (61) des cartes (60) de fonctions auxiliaires sont pressés contre des connecteurs correspondants (52a, 52b) prévus dans le compartiment (50) et assurent un contact entre les connecteurs.

10. Appareil de mesure tel que revendiqué dans l'une quelconque des revendications 1 à 9, **caractérisé en ce qu'**une partie d'extrémité des cartes (60) de fonctions auxiliaires située en face de ladite ouverture (37) est pourvue d'un ou de plusieurs connecteurs (63, 64), qui peuvent être reliés à un dispositif situé à l'extérieur de l'appareil de mesure après que le couvercle qui ferme ladite ouverture (37) a été retiré de l'appareil de mesure.

11. Appareil de mesure tel que revendiqué dans l'une quelconque des revendications 1 à 10, **caractérisé en ce que** le compartiment (50) qui reçoit les cartes (60) de fonctions auxiliaires est pourvu d'un dispositif de verrouillage (110), par lequel les cartes (60) de fonctions auxiliaires peuvent être verrouillées dans le compartiment (50) de sorte que leur retrait nécessite l'ouverture de la partie de couvercle (30) de l'appareil de mesure, en liaison avec quoi le sceau d'étalonnage de l'appareil de mesure doit être cassé.
